# EUROPEAN PATENT SPECIFICATION

(11) **EP 1 796 149 B1**
(45) Date of publication and mention of the grant of the patent: **18.10.2017**
(21) Application number: 05768426.8
(22) Date of filing: 03.08.2005
(51) Int. Cl.: H01L 21/205, H01L 21/31, C23C 16/44, H01L 21/00, C30B 13/06, C30B 13/24

(54) **QUARTZ JIG AND SEMICONDUCTOR MANUFACTURING EQUIPMENT**
QUARZ-EINSPANNVORRICHTUNG UND HALBLEITER-HERSTELLGERÄTE
DISPOSITIF DE SERRAGE EN QUARTZ ET ÉQUIPEMENT DE FABRICATION DE SEMI-CONDUCTEURS

(30) Priority: 24.08.2004 JP 2004243722
(43) Date of publication of application: 13.06.2007
(73) Proprietor: Shin-Etsu Handotai Co., Ltd., Tokyo (JP)
(72) Inventor: OTSUKA, Toru, Nishishirakawa-gun, Fukushima 961-8061 (JP); KANNO, Takao, Nishishirakawa-gun, Fukushima 961-8061 (JP)
(74) Representative: Ter Meer Steinmeister & Partner
(86) International application number: PCT/JP2005/014177
(87) International publication number: WO 2006/022128

(56) References cited:
- EP-A1- 1 132 950
- EP-A2- 1 058 291
- WO-A1-86/00096
- WO-A1-97/08743
- WO-A2-96/07199
- JP-A- 7 078 863
- JP-A- 7 193 015
- JP-A- 2000 349 031
- JP-A- 2003 100 650
- JP-A- 2003 218 039
- US-A- 5 304 248
- US-A- 5 938 850
- US-A1- 2002 025 657
- US-A1- 2003 029 570

## Description

### BACKGROUND OF THE INVENTION

### [Field of the Invention]

This invention relates to a quartz jig provided inside a semiconductor manufacturing apparatus allowing therein growth of an epitaxial layer on a main surface of a semiconductor wafer, capable of supporting a soaking jig which keeps, during epitaxial growth, uniform temperature of a susceptor allowing thereon placement of the semiconductor wafer, and has the top surface thereof aligned almost at the same level of height with the top surface of the susceptor, and a semiconductor manufacturing apparatus provided with the quartz jig.

EP1132950 A1 discloses a wafer support comprised in a semiconductor manufacturing system configured for performing an epitaxial growth process.

US 2003/0029570 A1 relates to a wafer holder, a wafer support member, a wafer boat and a heat treatment furnace, which are capable of sufficiently suppressing slip dislocations, without lower productivity and at low cost, in the high temperature heat treatment of silicon wafers. The wafer holder is composed of a wafer support plate and three or more wafer support members mounted on said wafer support plate. Each of the wafer support members has a wafer support portion. At least one of said wafer support members is a tilting wafer support member which has a plurality of upward, convex wafer support portions on the upper surface and is tiltable with respect to said wafer support plate. The wafer is supported by at least four wafer support portions. JP 2003 218039 describes a heat treatment equipment with a susceptor which is rotatably provided in a heat treatment vessel and user for placing a wafer, a preheating ring which is supported by a pedestal provided in the vessel and proximately surrounds the susceptor in a non-contact state, and heating equipment which heats the wafer placed on the susceptor. The preheating ring is formed so that the center of its inner periphery is off-centered, with respect to its outer periphery. After the ring is positioned so that the distance between the center of its inner periphery and the center of the susceptor becomes minimum by moving the ring around the susceptor, heat treatment is performed on the wafer.

As a semiconductor manufacturing apparatus used for manufacturing silicon epitaxial wafers and semiconductor devices, having conventionally been used, for example, is a CVD apparatus for growing a desired epitaxial layer on the surface of a wafer, by heating a silicon single-crystal wafer housed in a quartz chamber by radiation heat emitted from a lamp or a heater disposed outside the chamber, and by introducing a source gas, mainly composed of a silicon source gas such as trichlorosilane, and a hydrogen gas containing a dopant gas, into the chamber.

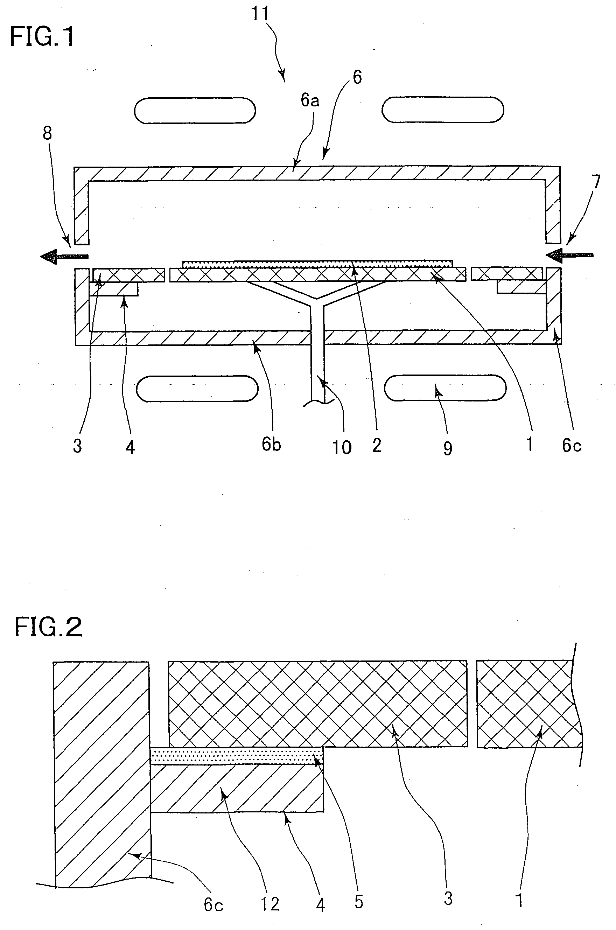

Procedures for allowing a thin film to grow on the main surface of a silicon single-crystal wafer using a semiconductor manufacturing apparatus (CVD apparatus 11) will be explained referring to FIG. 1. First, a susceptor support jig 10, having a susceptor 1 typically made of silicon carbide or the like placed thereon, is descended. The CVD apparatus 11 herein is adjusted to a wafer loading temperature, typically 650°C. A silicon single crystal wafer 2 is loaded into the CVD apparatus 11 by an unillustrated loading unit, from the direction normal to the sheet of drawing, and is placed in a pocket formed in the top surface of the susceptor 1. After an unillustrated loading/unloading port is tightly closed, the susceptor support jig 10 is elevated until the top surface of the susceptor 1 reaches almost the same level of height with the top surface of a soaking jig 3 surrounding the circumference of the susceptor 1.

After the susceptor 1 is elevated to that level, the inner atmosphere of a quartz chamber 6 is heated is to several hundred degrees centigrade to 1,200°C or around, typically to 1,100 to 1,180°C, by a heating device 9 disposed outside the quartz chamber 6. Radiation light emitted from the heating device 9 contains infrared radiation having a wavelength of 2 to 3 µm, but the light in this wavelength range transmits through a transparent-quartz-made chamber top plate 6a and a chamber bottom plate 6b composing the top and bottom surfaces of the quartz chamber 6, respectively, rather than being absorbed thereinto, so that the light can reach the silicon single crystal wafer 2 and the susceptor 1 without heating the chamber 6, and can heat the wafer and the susceptor through absorption by them. Halogen lamps or heaters, infrared lamps and so forth can be used as the heating device 9. The inner atmosphere of the CVD apparatus 11 herein is conditioned as having a hydrogen gas atmosphere, wherein native oxide film which resides on the main surface of the silicon single crystal wafer is removed by etching by the hydrogen gas.

The CVD apparatus 11 has a soaking jig 3 disposed so as to surround the susceptor 1. A material composing the soaking jig 3 is any one of silicon carbide, carbon, and a carbon base coated with silicon carbide, being almost same as that composing the susceptor 1. The soaking jig 3 is therefore heated by the radiation light from the heating device 9 to a temperature almost as high as the susceptor 1. If there were no soaking jig 3, the susceptor 1 would have a large temperature difference between outer circumference and the inner portion thereof, because the heated susceptor 1 would cause heat dissipation from the outer circumference and would cause temperature drop therein, whereas surrounding of the susceptor 1 with the soaking jig 3 which is heated to a temperature almost as high as the susceptor 1 can successfully suppress heat dissipation from the outer circumference of the susceptor 1, can thereby reduce temperature difference inside the susceptor 1, and makes it easier to keep a uniform temperature over the entire wafer 2.

The soaking jig 3 is supported by a quartz jig 4. In view of preventing heat of the soaking jig 3 from conducting and dissipating through the quartz jig 4, a material having been used for composing the quartz jig 4 is an opaque quartz. The quartz jig 4 composed of an opaque quartz can successfully prevent heat dissipation from the soaking jig 3, because the opaque quartz has a low heat conductivity, and can reflect infrared radiation emitted from the soaking jig 3 during the heat dissipation.

The silicon single crystal wafer 2 on the susceptor 1 is heated using the above-described susceptor 1 and the soaking jig 3, and after the temperature of the inner atmosphere of the CVD apparatus reaches a growth temperature (1,060 to 1,150°C or around, for example), the above-described source gas is supplied through a growth gas supply port 7 into the quartz chamber 6. The silicon source gas and the dopant gas contained in the source gas are decomposed under heating, the resultant silicon atoms and impurity atoms such as boron and phosphorus in the gas bind with silicon exposed to the main surface of the silicon single crystal wafer 2, and thereby a silicon epitaxial layer grows.

After completion of the growth of the silicon epitaxial layer, heating by the heating device 9 is terminated, and the inner atmosphere of the CVD apparatus is cooled to an unloading temperature (650°C or around, equivalent to the loading temperature). The susceptor 1 is descended together with the silicon epitaxial wafer 2 by the susceptor support jig 10. The silicon epitaxial wafer 2 is taken up from the susceptor 1 and out of the CVD apparatus 11 by an unillustrated transfer unit. By repeating the procedures described in the above, a plurality of silicon epitaxial wafers can be manufactured.

In the process of epitaxial growth described in the above, silicon by-product grows on the surface of the jig and so forth provided inside the CVD apparatus 11. Thus-grown silicon by-product delaminates from the surface of the jig, due to expansion and shrinkage of the jig caused typically by heating and cooling, and becomes particles. Adhesion of the particles onto the main surface of the wafer may induce crystal defects in the epitaxial layer. The crystal defects are known to degrade yield ratio of acceptable products and electrical characteristics, and are therefore desired to be suppressed to the lowest possible level.

On the other hand, the silicon by-product grown on the inner wall of the quartz chamber 6 may alter heat conductivity of the quartz chamber 6, and may make it impossible to achieve target process conditions, raising a need of periodical removal of the silicon by-product. One general practice for removing the silicon by-product is such as periodically introducing an etching gas such as hydrochloric acid gas through the gas supply port 7 into the quartz chamber 6, upon completion of every single or more cycles (5 cycles, for example) of the manufacturing process of the silicon epitaxial wafer described in the above. The etching gas used herein, however, etches also the various components in the quartz chamber 6, such as the soaking jig 3, the quartz jig 4, the chamber top plate 6a and the chamber side wall 6c, and consequently degrades these components over a long period of use. In particular, the components made of opaque quartz, such as the quartz jig 4 and the chamber side wall 6c, having only a small density due to micro-voids therein, are more susceptible to degradation by the etching. Once the voids are exposed as a result of degradation, a large amount of quartz between the voids is released by the etching, raising a cause of particle pollution. A countermeasure sometimes taken is such as disassembling the quartz chamber 6 and its internal jigs after fabrication of silicon epitaxial wafers continued over a predetermined duration of time, or repeated a predetermined number of times, and cleaning them in an acidic solution (for example, a mixed aqueous solution of hydrofluoric acid and nitric acid) so as to remove the silicon by-product, but the same problem still remains unsolved.

For the purpose of preventing growth of the silicon by-product adhering to a source gas supply nozzle, which is one of the jigs provided inside the CVD apparatus, Japanese Laid-Open Patent Publication No. H7-86178 proposes to configure the source gas supply nozzle using an opaque quartz for the base portion thereof, and using a transparent quartz for the end portion thereof. In this configuration, however, the nozzle base portion composed of the opaque quartz is exposed to the etching gas, and therefore cannot be prevented from degrading, even if the silicon by-product could be etched.

Japanese Laid-Open Patent Publication No. H8-102447 proposes a method of preventing generation of the particles caused by delamination of the by-product, by using the quartz jig, typically adapted to the CVD apparatus and so forth, composed of a sand-blasted transparent quartz in a portion thereof brought into contact with the wafer. Sand blasting accomplished by blasting quartz powder against the quartz jig may, however, result in adhesion of the quartz powder onto the quartz jig. Thus-adhered quartz powder may delaminate from the quartz jig due to expansion and shrinkage of the quartz jig caused by heating and cooling inside the CVD apparatus, and may be causative of additional particle pollution.

Japanese Laid-Open Patent Publication No. H10-256161 proposes a method of preventing surface degradation of the quartz jig of the CVD apparatus, by modifying the surface by annealing. The surface modification is, however, only such as making the extra-thin surficial portion of the jig transparent, so that a problem still remains in that the unmodified opaque quartz portion will readily be exposed and degraded at an accelerated pace, if the surface is eroded by hydrogen gas or the etching gas. Another problem is such that any by-product grown on the surface may be sometimes delaminated together with quartz composing the extra-thin surficial portion of the jig, and may consequently accelerate the degradation.

Japanese Laid-Open Patent Publication No. 2001-102319 describes that impurity is successfully prevented from adhering onto the surface of a heating element, by composing the heating element of a batch-type annealing apparatus with a smooth quartz plate having no voids exposed to the surface. Manufacturing of the quartz plate, however, needs extremely complicated processes, such as forming a metal film on one surface of each of two thin quartz plates, bonding two these quartz plates so as to bring the surfaces having the metal films formed thereon into contact with each other, and then fusing them using a burner or the like. It is still also necessary to procure an apparatus such as a vacuum evaporation apparatus forming the metal films.

This invention was conceived after considering the above-described problems, and an object thereof is to provide a quartz jig supporting a soaking jig, capable of suppressing generation of particles in a semiconductor manufacturing apparatus, and a semiconductor manufacturing apparatus provided with the quartz jig.

After extensive investigations, the present inventors found out that the particles generated in the semiconductor manufacturing apparatus are ascribable to the silicon by-product grown on the surface of the quartz jig and delaminated therefrom, and also to quartz *per se* released from the quartz jig as a result of degradation of the quartz jig. More specifically, there are two cases, firstly such that the silicon by-product grows on the surface of the jigs in the apparatus, and then delaminates due to expansion and shrinkage of the jigs caused by heating and cooling, and thereby becomes the particles; and secondly such that the fine quartz fragment is released from the opaque quartz jig having in the inner portion thereof fine and high-density voids, and thereby becomes the particles. It is also anticipated that repetitive introduction of the etching gas into the semiconductor manufacturing apparatus, aimed at removing the silicon by-product, may cause rapid degradation of the opaque quartz jig having therein the fine and high-density voids, so that release of quartz may further be accelerated.

The present inventors placed a focus on a quartz jig, out of all quartz jigs in the semiconductor manufacturing apparatus, which can readily be elevated in the temperature due to contact with the soaking jig, and allowing thereon most rapid growth of the silicon by-product, and finally completed the invention described below.

### SUMMARY OF THE INVENTION

A quartz jig of this invention is such as being provided inside a semiconductor manufacturing apparatus allowing therein growth of an epitaxial layer on the main surface of a semiconductor wafer, capable of supporting a soaking jig which keeps, during epitaxial growth, uniform temperature of a susceptor allowing thereon placement of the semiconductor wafer, and has the top surface thereof aligned almost at the same level of height with the top surface of the susceptor, being composed of transparent quartz at least in a portion thereof brought into contact with the soaking jig.

This quartz jig is composed of a transparent quartz specifically in the portion thereof brought into contact with the soaking jig, where the silicon by-product tends to grow most rapidly. The transparent quartz is more dense as compared with the opaque quartz, and has almost no voids contained therein, and can thereby largely suppress any possibility of releasing, together with the silicon by-product, of quartz composing the surficial portion of the jig, and any possibility of dusting, in a particle form, of fine quartz between the voids as a result of exposure to the etching gas for removing the silicon by-product.

Next, the quartz jig of this invention preferably has a core portion composed of an opaque quartz, and a surficial portion composed of a transparent quartz, and covers the core portion so as to prevent the surface thereof from being exposed. This configuration is effective not only in that the effects described in the above can be obtained over the entire surface of the quartz jig by virtue of the transparent quartz (surficial portion), but also in that the soaking jig can be more readily kept at a desired temperature, because the opaque quartz (core portion) which lies under the transparent quartz (surficial portion) reflects infrared radiation or the like, even if heat release by the infrared radiation or the like occurs from the soaking jig.

Next, the quartz jig of this invention may have a geometry such as being notched in a portion which overlaps a transfer path of a semiconductor wafer loaded to and unloaded from the semiconductor manufacturing apparatus. Because no quartz jig resides over the transfer path of a semiconductor wafer during loading and unloading of the wafer, this configuration can successfully prevent particles, derived from the silicon by-product grown on, and delaminated from the surface of the quartz jig, from adhering to the main surface of the wafer.

Moreover, the quartz jig of this invention may have a geometry such as being notched in a portion in the vicinity of a gas supply port introducing therethrough a growth gas into the semiconductor manufacturing apparatus. By excluding the quartz jig from an area in the vicinity of the gas supply port, where the silicon by-product is likely to grow in the process of epitaxial growth, the silicon by-product is effectively prevented from growing on the surface of the quartz jig.

Because the transparent quartz is used for the surficial portion of the quartz jig supporting the soaking jig as described in the above, the semiconductor manufacturing apparatus provided with the above-described quartz jig can successfully prevent the quartz composing the surface of the jig from releasing together with the silicon by-product in the process of the delamination. The apparatus can successfully suppress also pollution of the wafer by the particles ascribable to micro-grains of quartz, even if the quartz jig is exposed to and etched by the etching gas. Furthermore, by making the geometry of the quartz jig as being notched as described in the above, adhesion of the silicon by-product onto the surface of the wafer and consequent pollution thereof can be suppressed, even if the silicon by-product delaminates from the quartz jig.

### BRIEF DESCRIPTION OF THE DRAWINGS

FIG. 1 is a schematic sectional view of the semiconductor growth apparatus of this invention;
FIG. 2 is a schematic sectional view showing a structure of the quartz jig of this invention;
FIG. 3 is a schematic sectional view showing another example of the quartz jig of this invention;
FIG. 4 is a schematic front elevation of another example of the quartz jig of this invention;
FIG. 5 is a schematic front elevation of another example of the quartz jig of this invention;
FIG. 6 is a schematic sectional view showing a structure of a conventional quartz jig;
FIG. 7 is a schematic front elevation showing an arrangement of a susceptor, a wafer, a soaking jig and the quartz jig; and
FIG. 8 is a graph showing comparison among particle counts in Examples 1 to 4 and Comparative Example.

### BEST MODES FOR CARRYING OUT THE INVENTION

Paragraphs below will describe embodiments of this invention referring to the attached drawings.

As shown in FIG. 1, the semiconductor manufacturing apparatus 11 has, as being incorporated therein, components and jigs such as the susceptor 1, the soaking jig 3, the quartz jig 4, the quartz chamber 6, the gas supply port 7, a gas discharge port 8, and the susceptor support jig 10. For the case where the silicon single crystal wafer 2 is loaded into thus-configured semiconductor manufacturing apparatus 11, aiming at growing a silicon epitaxial layer on the main surface of the wafer 2, the inner atmosphere of the semiconductor manufacturing apparatus 11 is conditioned to a desired temperature, and a growth gas is introduced through the gas supply port 7. The silicon epitaxial layer can thus be grown on the main surface of the silicon single crystal surface wafer 2, wherein a thin polysilicon layer also grows on the surfaces of the susceptor 1, the soaking jig 3, the quartz jig 4, the quartz chamber 6, the gas supply port 7, the gas discharge port 8, and the susceptor support jig 10, forming the silicon by-product.

The susceptor 1 and the soaking jig 3 herein are composed of silicon carbide in the surficial portion thereof, having a thermal expansion coefficient close to that of the silicon by-product, so that the susceptor 1 and the soaking jig 3 are considerably less likely to cause delamination of the silicon by-product from the surfaces thereof, as compared with the quartz-made jigs. Therefore, delamination of the silicon by-product can fully be suppressed, by removing the silicon by-product from the surfaces by etching using hydrochloric acid gas periodically introduced through the gas supply port 7.

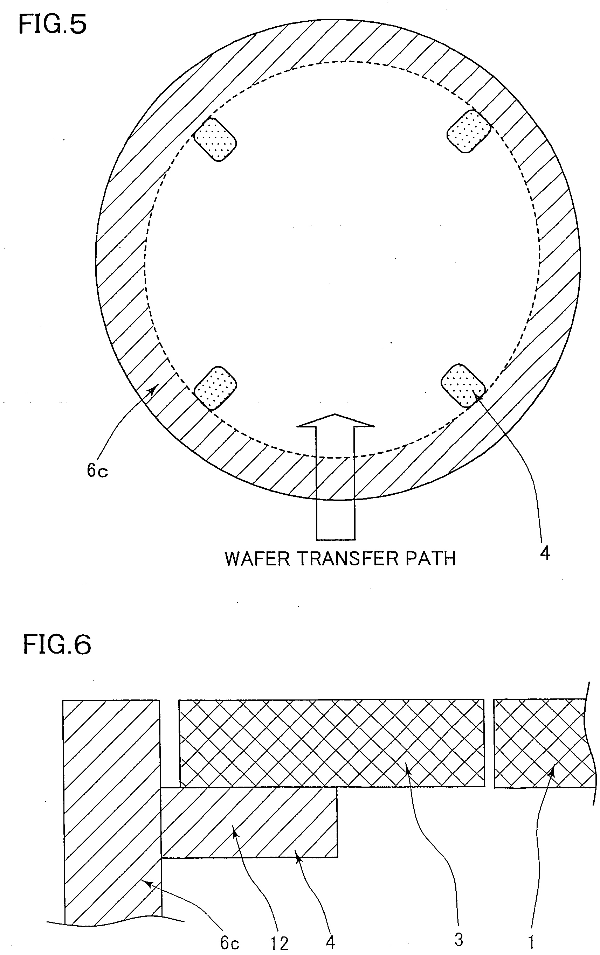

Moreover, the top surface of the soaking jig 3 and the top surface of the susceptor 1 are aligned almost at the same level of height, while keeping only a small gap in between, as shown in FIG. 6, so that growth gas hardly flows into the space under the soaking jig 3 and the susceptor 1, except for an area in an extreme vicinity of the soaking jig 3 and the susceptor 1. The susceptor support jig 10 will, therefore, have only an extremely thin silicon by-product grown on the surface thereof, so that delamination of the silicon by-product can fully be suppressed, by periodically removing the silicon by-product using hydrochloric acid gas.

The quartz chamber 6, the gas supply port 7 and the gas discharge port 8 are made of quartz, and show a low heat conductivity. These jigs, disposed apart from the susceptor 1 and the soaking jig 3, become not so high in the temperature, and therefore allow thereon growth of only an extremely thin silicon by-product, so that periodical removal of the silicon by-product using hydrochloric acid gas is sufficient for suppressing the delamination of the by-product. Accordingly, even if the chamber side wall 6c, the gas supply port 7 and the gas discharge port 8 are composed of the opaque quartz, they allow thereon growth of only a thin silicon by-product, producing only a small amount of micro-grains of quartz possibly released together with the by-product. Moreover, temperature of the inner atmosphere of the semiconductor manufacturing apparatus 11 is elevated to a desired temperature during the etching using a hydrochloric acid gas aiming at efficiently proceeding the etching, wherein these jigs become not so high in the temperature as described in the above, so that the etching of quartz by the hydrochloric acid gas can proceed only to an extremely limited degree, so that there is only a low possibility that the micro-grains of quartz are released to produce the particles.

On the other hand, the quartz jig 4 supports the soaking jig 3 heated to high temperatures, and is therefore heated almost to as high as the soaking jig 3. As described above, it is very unlikely that a large amount of growth gas flows behind the susceptor 1 and the soaking jig 3, but there is the growth gas flown into an area in the extreme vicinity of the back surfaces of the susceptor 1 and the soaking jig 3. Therefore, growth of the silicon by-product is promoted on the side surface and back surface of the quartz jig 4. In particular, growth of the silicon by-product is further promoted in a gap between the soaking jig 3 and the quartz jig 4, because the gas can flow through the gap only extremely slowly, and thereby the growth gas tends to stagnate therein.

Also the silicon by-product grown on the quartz jig 4 can be removed using hydrochloric acid gas or the like, but the quartz jig 4 allows thereon growth of the silicon by-product faster than on other components and jigs for the reason described in the above, and is disposed behind the soaking jig 3 where the etching gas is less likely to flow therearound. In particular, it is hard for the etching gas to flow through the gap between the soaking jig 3 and the quartz jig 4. For this reason, the silicon by-product may delaminate due to expansion and shrinkage of the quartz jig 4 heated and cooled in the process of epitaxial growth, and may become a potent source of the particles in the quartz chamber 6. The delamination of the silicon by-product may sometimes occur in such a manner that quartz in the surficial portion of the quartz jig 4 binds to the by-product, releases together therewith, and thereby degradation of the quartz jig 4 may be accelerated.

In view of suppressing the above-described nonconformity, one possible process may be such as thoroughly removing the silicon by-product grown on the surface of the quartz jig 4, by supplying a large volume of etching gas, such as hydrochloric acid gas. A large volume of etching gas, however, accelerates degradation of the quarts jigs other than the quartz jig 4, such as the quartz chamber 6, the gas supply port 7 and the gas discharge port 8, and may therefore raise frequency of replacement of the components and jigs of the semiconductor manufacturing apparatus 11, and may consequently degrade the operation efficiency of the apparatus.

Moreover, for the case where the surficial portion of the quartz jig 4 is composed of the opaque quartz, removal of the silicon by-product under a sufficient flow of the etching gas concomitantly proceeds etching of the surface of the quartz jig 4 to thereby degrade the jig 4, so that micro-grains of quartz which reside between the voids of the opaque quartz may be exposed and released, possibly producing the particles.

Now in this invention, the top surface of the quartz jig 4, brought into contact with the soaking jig 3, is composed of the transparent quartz as shown in FIG. 2. The top surface of the quartz jig 4 tends to become hottest, because of contact with the soaking jig 3. The top surface of the quartz jig 4 is located in the vicinity of the gap between the susceptor 1 and the soaking jig 3, where the growth gas concentration becomes higher, and is very likely to stagnate in the gap between the top surface of the quartz jig 4 and the lower surface of the soaking jig 3. For this reason, the top surface of the quartz jig 4 is where the silicon by-product is most likely to grow. Composing the top surface of the quartz jig 4 using the transparent quartz, having no voids and having dense arrangement of quartz molecules, is now successful in desirably preventing release of a part of the top surface of the quartz jig 4 together with the silicon by-product, even when the silicon by-product delaminates. Even if the etching is carried out using hydrochloric acid or the like, release of the micro-grains of quartz, such as those reside between the voids in the opaque quartz, is successfully avoidable, because the transparent quartz scarcely has the voids.

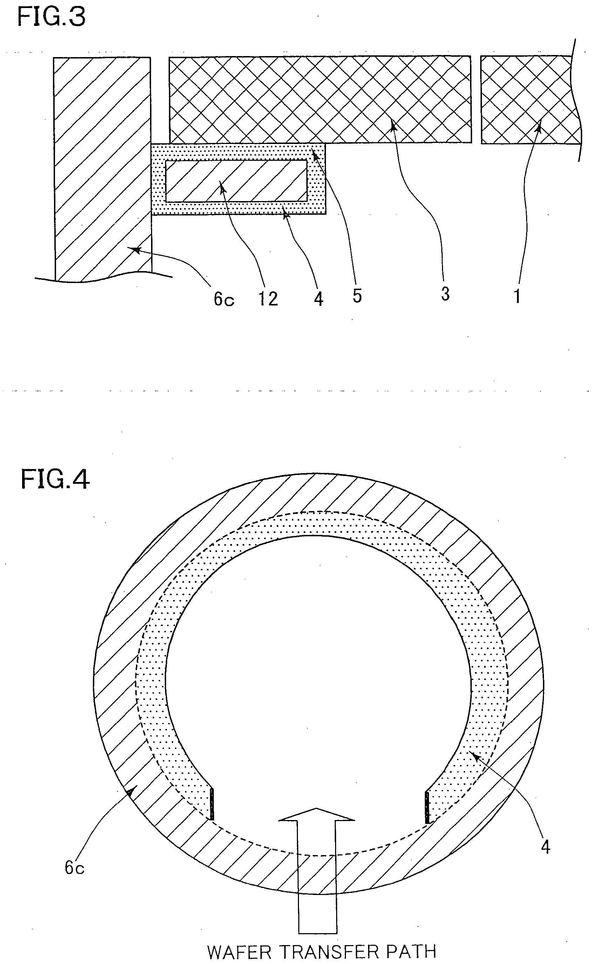

The quartz jig 4 is more preferably composed of the transparent quartz not only in the top surface thereof, but also in the side surface and in the lower surface thereof (that is, over the entire surface), as shown in FIG. 3. In other words, the quartz jig 4 can be configured as having a core portion composed of the opaque quartz, and a surficial portion composed of the transparent quartz. Of the surfaces of the quartz jig 4, a surface on which the silicon by-product is most likely to grow is the top surface of the quartz jig 4 as described in the above, and also the side surface and lower surface of the jig 4 promote thereon growth of the silicon by-product, because also the side surface and the lower surface tends to be elevated in temperature as compared with other jigs and components. Composing also these surfaces with the transparent quartz can successfully prevent releasing of a part of the quartz jig 4 together with the silicon by-product, even if delamination of the silicon by-product should occur. The transparent quartz scarcely has voids, and can desirably prevent release of the micro-grains, such as residing between the voids in the opaque quartz, even under etching using hydrochloric acid or the like. The opaque quartz and the transparent quartz can be laminated by any publicly-known method, such as stacking the both and fusing them using a burner.

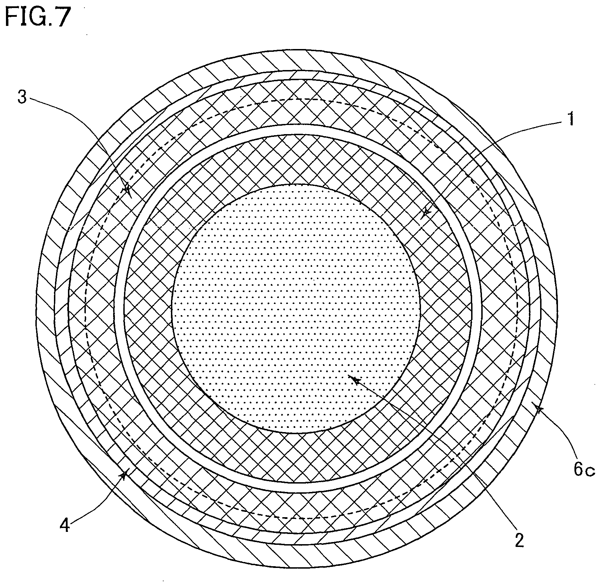

Although the conventional ring-form geometry (see FIG. 7) might be acceptable, it is also desirable to form the quartz jig 4 into a geometry, as shown in FIG. 4, as being notched in a portion thereof so that the quartz jig 4 does not overlap the transfer path of the wafer. Adoption of this sort of geometry for the quartz jig 4 can suppress dropping and adhesion of the silicon by-product in a form of particles onto the main surface of the wafers under transportation, even if the silicon by-product delaminates from the quartz jig 4.

It is also allowable herein to adopt the quartz jig 4 being notched also in a portion where the silicon by-product is likely to grow thereon. For example, a portion in the vicinity of the gas supply port 7 has a high growth gas concentration, where the silicon by-product can readily grow on the surface of the quartz jig 4 by the growth gas which flows behind the soaking jig 3. Therefore, it is preferable to notch the quartz jig 4 specifically in a portion located around the gas supply port 7. Another preferable example of the quartz jig 4 is shown in FIG. 5. All of the quartz jigs 4 described in the above are fixed to the quartz chamber side wall 6c.

A silicon epitaxial wafer having only a small amount of particles adhered on the silicon epitaxial layer can be manufactured, if silicon epitaxial growth is proceeded on the main surface of the silicon single crystal wafer 2 placed on the susceptor 1 in the CVD apparatus 11 using the above-described quartz jig 4. Conditions for the silicon epitaxial growth herein may be adjusted to any publicly-known ones described in the above.

The foregoing paragraphs have described the exemplary cases of this invention applied to a single-wafer-processing-type CVD apparatus, whereas this invention is applicable not only to the single-wafer-processing-type CVD apparatus but also to a batch-type CVD apparatus. The gas etching of the interior of the CVD apparatus was exemplified as using hydrochloric acid gas, whereas any other reducing gases can, of course, ensure the same effects.

### Examples

### (Example 1)

A silicon single crystal wafer of a p-conductivity type, 200 mm in diameter and with a <100> crystal orientation was prepared, and loaded into the single-wafer-processing-type CVD apparatus as shown in FIG. 1. A quartz jig used herein in the CVD apparatus was the ring-form jig (see FIG. 2) composed of the opaque quartz, having on the surface thereof, which is brought into contact with the soaking jig, the transparent quartz of 1 mm thick fused therewith. The silicon single crystal wafer loaded into the CVD apparatus was heated to 1,050°C, hydrogen-diluted trichlorosilane as the source gas was introduced into the quartz chamber, and thereby a silicon epitaxial layer of 6 µm thick was grown on the main surface of the wafer. This process was repeated 10 times, and dry etching of the interior of the CVD apparatus was carried out using hydrochloric acid gas. Processing of 10 silicon wafers and a single time of dry etching were carried out in a successive manner.

### (Example 2)

A silicon single crystal wafer same as that described in Example 1 was prepared, and a silicon epitaxial layer was grown to as thick as 6 µm on the main surface of the wafer under same conditions. The quartz jig used herein in the CVD apparatus was a ring-form jig (see FIG. 3) composed of the opaque quartz, having on the entire surface thereof the transparent quartz of 1 mm thick fused therewith.

### (Example 3)

A silicon single crystal wafer same as that described in Example 1 was prepared, and a silicon epitaxial layer was grown to as thick as 6 µm on the main surface of the wafer under same conditions. The quartz jig used herein was a jig (see FIG. 4) composed of the opaque quartz, having on the surface thereof, which is brought into contact with the soaking jig, the transparent quartz of 1 mm thick fused therewith, and notched in a portion thereof which overlaps a transfer path of the wafer.

### (Example 4)

A silicon single crystal wafer same as that described in Example 1 was prepared, and a silicon epitaxial layer was grown to as thick as 6 µm on the main surface of the wafer under same conditions. The quartz jig used herein was a jig composed of the opaque quartz, having on the surface thereof, which is brought into contact with the soaking jig, the transparent quartz of 1 mm thick fused therewith, and having the geometry shown in FIG. 5.

### (Comparative Example)

A silicon single crystal wafer same as that described in Example 1 was prepared, and a silicon epitaxial layer was grown to as thick as 6 µm on the main surface of the wafer under same conditions. The quartz jig used herein in the CVD apparatus was the conventional jig (see FIG. 6) composed of the opaque quartz exposed over the entire surface thereof.

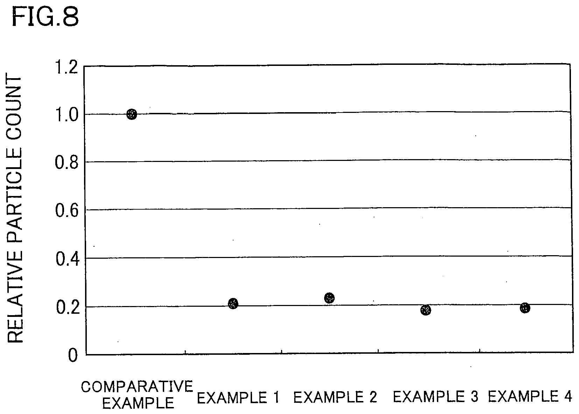

Based on the above-described embodiments, and in the individual Examples and Comparative Example, 3,000 wafers in total were processed. Thereafter, additionally similar 100 silicon wafers were processed in succession, 100 these wafers were then observed by a particle counter (Model SP-1, from KLA-Tencor Corporation), so as to count the particles on the main surfaces of the silicon epitaxial wafers, and an average value of the particles counts of 0.12 µm or larger was calculated for 100 these wafers. FIG. 8 is a graph comparatively showing the results, expressed by assuming an average of the particle counts for Comparative Example using the conventional quartz jig as 1. It is found that use of the quartz jigs of this invention successfully reduced the particle counts by a factor of approximately 5.

## Claims

1. A semiconductor manufacturing apparatus configured for allowing therein growth of an epitaxial layer on a main surface of a semiconductor wafer (2), wherein the semiconductor manufacturing apparatus comprises
a gas supply port (7) for introducing therethrough a growth gas into the semiconductor manufacturing apparatus,
a susceptor being adapted for allowing thereon placement of the semiconductor wafer (2), and
a soaking jig (3) designed for keeping, during epitaxial growth, uniform temperature of the susceptor (1) and having a top surface aligned almost at the same level of height with the top surface of the susceptor (1),
**characterized in that**
the semiconductor manufacturing apparatus further comprises a quartz jig (4),
wherein the quartz jig (4) is designed for supporting the soaking jig (3),
wherein the quartz jig (4) is composed of transparent quartz (5) at least in a portion thereof brought into contact with the soaking jig (3),
wherein the quartz jig (4) has a geometry such as being notched in a portion which overlaps a transfer path of a semiconductor wafer (2) loaded to and unloaded from the semiconductor manufacturing apparatus, and
wherein the quartz jig (4) has a geometry such as being notched in a portion in the vicinity of the gas supply port (7).

2. The semiconductor manufacturing apparatus as claimed in claim 1,
wherein the quartz jig (4) comprises a core portion composed of an opaque quartz (12) and a surficial portion composed of a transparent quartz (5), and covering the core portion so as to prevent the surface thereof from being exposed.

## Patentansprüche

1. Halbleiterherstellungsvorrichtung, die dazu ausgelegt ist, darin ein Wachstum einer epitaktischen Schicht auf einer Hauptoberfläche eines Halbleiterwafers (2) zu ermöglichen, wobei die Halbleiterherstellungsvorrichtung Folgendes umfasst:
eine Gasversorgungsöffnung (7), um durch sie ein Wachstumsgas in die Halbleiterherstellungsvorrichtung einzuleiten,
einen Suszeptor, der dazu geeignet ist, eine Platzierung des Halbleiterwafers (2) zu ermöglichen, und
eine Warmhalteeinrichtung (3), die dazu ausgelegt ist, während des epitaktischen Wachstums eine gleichförmige Temperatur des Suszeptors (1) zu erhalten, und die eine obere Oberfläche aufweist, die mit der oberen Oberfläche des Suszeptors (1) nahezu auf gleicher Höhe ist,
**dadurch gekennzeichnet, dass**
die Halbleiterherstellungsvorrichtung ferner eine Quarzeinrichtung (4) aufweist,
wobei die Quarzeinrichtung (4) zum Tragen der Warmhalteeinrichtung (3) ausgelegt ist,
wobei die Quarzeinrichtung (4) zumindest in einem Abschnitt davon, der mit der Warmhalteeinrichtung (3) in Kontakt gebracht wird, aus durchsichtigem Quarz (5) besteht,
wobei die Quarzeinrichtung (4) eine Geometrie aufweist, derart, dass sie in einem Abschnitt eingekerbt ist, der mit einem Transportweg eines Halbleiterwafers (2) überlappt, der auf die Halbleiterherstellungsvorrichtung geladen und aus dieser ausgeladen wird und
wobei die Quarzeinrichtung (4) eine Geometrie aufweist, derart, dass sie in einem Abschnitt in der Nähe der Gasversorgungsöffnung (7) eingekerbt ist.

2. Halbleiterherstellungsvorrichtung nach Anspruch 1,
wobei die Quarzeinrichtung (4) einen Kernabschnitt, der aus undurchsichtigem Quarz (12) besteht, und einen Oberflächenabschnitt, der aus durchsichtigem Quarz (5) besteht und den Kernabschnitt so bedeckt, dass verhindert wird, dass die Oberfläche davon freiliegt, umfasst.

## Revendications

1. Appareil de fabrication de semi-conducteur configuré pour permettre en lui-même la croissance d'une couche épitaxiale sur une surface principale d'une plaquette de semi-conducteur (2), ledit appareil de fabrication de semi-conducteur comprenant
un orifice d'alimentation de gaz (7) pour introduire à travers celui-ci un gaz de croissance dans l'appareil de fabrication de semi-conducteur,
un suscepteur adapté pour permettre de placer sur celui-ci la plaquette de semi-conducteur (2), et
une monture de trempage (3) conçue pour maintenir, pendant la croissance épitaxiale, une température uniforme du suscepteur (1) et ayant une surface supérieure alignée au moins au même niveau de hauteur que la surface supérieure du suscepteur (1),
**caractérisé en ce que**
l'appareil de fabrication de semi-conducteur comprend en outre une monture en quartz (4),
dans lequel la monture en quartz (4) est conçue pour supporter la monture de trempage (3),
dans lequel la monture en quartz (4) est composée de quartz transparent (5), au moins dans une portion d'elle-même amenée en contact avec la monture de trempage (3),
dans lequel la monture en quartz (4) a une géométrie qui présente une encoche dans une portion qui recouvre un trajet de transfert d'une plaquette de semi-conducteur (2) chargée sur et déchargée depuis l'appareil de fabrication de semi-conducteur, et
dans lequel la monture en quartz (4) a une géométrie qui présente une encoche dans une portion au voisinage de l'orifice d'alimentation de gaz (7).

2. Appareil de fabrication de semi-conducteur selon la revendication 1, dans lequel la monture en quartz (4) comprend une portion d'âme composée d'un quartz opaque (12) et une portion superficielle composée d'un quartz transparent (5), et couvrant la portion d'âme de manière à empêcher que la surface de celle-ci soit exposée.
